# EUROPÄISCHE PATENTSCHRIFT

(11) **EP 2 394 278 B1**
(45) Veröffentlichungstag und Bekanntmachung des Hinweises auf die Patenterteilung: **31.08.2016**
(21) Anmeldenummer: 10703070.2
(22) Anmeldetag: 09.02.2010
(51) Int. Cl.: H01F 17/04, H01F 41/12

(54) **HOCHFREQUENZ-SCHWINGDROSSEL**
HIGH-FREQUENCY SWINGING CHOKE
BOBINE À INDUCTANCE VARIABLE HAUTE FRÉQUENCE

(30) Priorität: 09.02.2009 DE 102009008110
(43) Veröffentlichungstag der Anmeldung: 14.12.2011
(73) Patentinhaber: Epcos AG, 81669 München (DE)
(72) Erfinder: RÖLLGEN, Bernhard, 35576 Wetzlar (DE); CARDARELLI, Herbert-Maurizio, 81737 München (DE)
(74) Vertreter: Epping - Hermann - Fischer
(86) Internationale Anmeldenummer: PCT/EP2010/051578
(87) Internationale Veröffentlichungsnummer: WO 2010/089413

(56) Entgegenhaltungen:
- EP-A1- 1 895 549
- DE-A1-102007 007 117
- DE-A1-102008 016 488
- GB-A- 1 105 486

## Beschreibung

Aus der Druckschrift EP 1405322 B1 ist eine Hochfrequenz-Schwingdrossel bekannt. In der Druckschrift EP 1895549 A1 ist ein induktives Element beschrieben, bei dem Kerne, um die eine Wicklung angeordnet ist, in einem Stapel angeordnet sind.

Eine zu lösende Aufgabe ist es, eine Hochfrequenz-Schwingdrossel anzugeben, die geringe Verluste aufweist.

Die Aufgabe wird durch eine Hochfrequenz-Schwingdrossel nach Patentanspruch 1 gelöst. Vorteilhafte Ausgestaltungen der Hochfrequenz-Schwingdrossel sind Gegenstand von Unteransprüchen.

Es wird eine Hochfrequenz-Schwingdrossel angegeben, die wenigstens zwei in Längsrichtung nebeneinander angeordnete Stabkerne aufweist. In einer bevorzugten Ausführungsform sind die Stabkerne nahezu parallel zueinander angeordnet.

Die Stabkerne weisen jeweils wenigstens einen Wickel auf. Vorzugsweise weisen die Stabkerne jeweils wenigstens eine Länge auf, die über die Länge des Wickels hinausgeht. An den jeweiligen Enden weisen die Stabkerne vorzugsweise einen wickelfreien Bereich auf.

Die Wickel sind vorzugsweise in Serie geschaltet.

In einer Ausführungsform sind die Wickelrichtungen der wenigstens zwei Wickel entgegengesetzt gerichtet.

Vorzugsweise sind die Flussrichtungen der von den Wickeln induzierten Magnetfelder zweier nebeneinander liegender Wickel entgegengesetzt gerichtet.

In einer weiteren Ausführungsform, bei der die Hochfrequenz-Schwingdrossel mehr als zwei Wickel aufweist, weisen vorzugsweise die nebeneinander angeordneten Wickel entgegengesetzte Wickelrichtungen auf. Die Flussrichtungen der von den Wickeln induzierten Magnetfelder weisen vorzugsweise abwechselnd entgegengesetzte Richtungen auf.

Im Betrieb bilden die in der Schwingdrossel induzierten Magnetfelder der Hochfrequenz-Schwingdrossel wenigstens einen geschlossenen Magnetkreis.

In einer Ausführungsform weist der Magnetkreis der Hochfrequenz-Schwingdrossel wenigstens einen Luftspalt auf.

Der Luftspalt der Hochfrequenz-Schwingdrossel ist in einer Ausführungsform wenigstens in zwei Teilluftspalte aufgeteilt. Die Teilluftspalte befinden sich vorzugsweise im Bereich der wickelfreien Enden wenigstens zweier nebeneinander angeordneter Stabkerne.

In einer Ausführungsform sind die Wickel auf den Stabkernen derart angeordnet, dass nur ein Teil der Stabkerne in Längsrichtung von den Wickeln umgeben ist.

In einer Ausführungsform sind mindestens 50 % der Länge eines Stabkerns vom Wickel umgeben.

Vorzugsweise sind die wenigstens zwei Stabkerne der Hochfrequenz-Schwingdrossel über eine Länge von jeweils über 50 % der Länge der Stabkerne von Wickeln umgeben.

In einer Ausführungsform der Hochfrequenz-Schwingdrossel weisen die Wickel unterschiedliche Längen auf. Als Länge eines Wickels ist die Längenabmessung des Wickels im aufgewickelten Zustand zu verstehen.

Bei einer Ausführungsform der Hochfrequenz-Schwingdrossel mit drei Stabkernen und drei Wickeln können zwei der Wickel die gleich Längen aufweisen und ein dritter Wickel eine größere oder kürzere Länge aufweisen. Es ist auch möglich, dass die drei Wickel jeweils unterschiedliche Längen aufweisen. Bei einer Ausführungsform mit drei nebeneinander liegenden Stabkernen weist der mittlere Stabkern vorzugsweise größere Abmessungen auf als die außen liegenden Stabkerne.

In einer Ausführungsform weisen die Wickel der Hochfrequenz-Schwingdrossel eine Schutzschicht aus Kunststoff auf.

Die Schutzumhüllung aus Kunststoff ist vorzugsweise derart ausgeführt, dass die wickelfreien Enden der Stabkerne frei von der Schutzumhüllung aus Kunststoff sind. In einer weiteren Ausführungsform ist es jedoch auch möglich, dass die wickelfreien Enden der Stabkerne durch eine Schutzumhüllung aus Kunststoff umhüllt sind. Vorzugsweise sind wenigstens Anschlusskontakte der Hochfrequenz-Schwingdrossel zumindest teilweise frei von einer Schutzumhüllung, um kontaktierbar zu sein.

In einer Ausführungsform der Hochfrequenz-Schwingdrossel sind die freien Enden der Wickel als lötfähige Kontakte ausgebildet. In einer weiteren Ausführungsform sind an den Enden der Wickel Lötfahnen beziehungsweise weitere Vorrichtungen zur elektrischen Kontaktierung oder zum elektrischen Anschluss der Hochfrequenz-Schwingdrossel angeordnet.

In einer Ausführungsform weist die Hochfrequenz-Schwingdrossel vorzugsweise bei maximal einem Drittel der Sättigungsmagnetisierung der Stabkerne in etwa die maximale Flussdichte der Stabkerne auf.

In einer Ausführungsform der Hochfrequenz-Schwingdrossel dienen wenigstens 50 % der effektiven magnetischen Länge des Stabkerns zur Bildung des Magnetfelds der Drossel.

In einer Ausführungsform umfassen die Stabkerne Ferrit. Die Stabkerne können jedoch auch weitere geeignete Materialien umfassen.

In einer Ausführungsform sind die Wickel auf den Stabkernen vorzugsweise derart ausgeführt, dass die Wickel mehrere Wickellagen umfassen, die über die Gesamtlänge der Wickel jeweils einen konstanten Abstand zu der Wickelachse der Wickel aufweisen.

In einer Ausführungsform ist die Hochfrequenz-Schwingdrossel mit einer Vergussmasse umhüllt.

Die Hochfrequenz-Schwingdrossel weist einen geschlossenen Magnetkreis auf, der einen großen Luftspalt umfasst. In der zuvor beschriebenen Hochfrequenz-Schwingdrossel ist der Luftspalt außerhalb der Wicklungen angeordnet. Durch eine derartige Anordnung können die von Streufeldern verursachten Verluste gering gehalten werden.

Durch den Aufbau einer zuvor beschriebenen Hochfrequenz-Schwingdrossel ist im Vergleich zu einer Drossel mit Doppel-E-Kern wenig Ferritmaterial für die Stabkerne nötig, das nur geringfügig ausgesteuert wird. Bei Ferritstabkernen für Drosseln nehmen die Kernverluste mindestens quadratisch bis maximal kubisch mit der Magnetisierung der Stabkerne zu. Luftspalt beziehungsweise Luftstrecken weisen im Gegensatz keine Verluste auf. Durch optimierte Stabkerne weist die Hochfrequenz-Schwingdrossel nur vergleichsweise minimale Verluste auf.

Die zuvor beschriebene Hochfrequenz-Schwingdrossel weist wenigstens zwei Wicklungen mit einer hohen Anzahl Windungen, wenigstens einen in zwei Teilluftspalte aufgeteilten großen Luftspalt sowie relativ kurze ferrithaltige Stabkerne auf. Durch einen derartigen Aufbau kann die maximale Flussdichte im ferrithaltigen Stabkern weit unterhalb der Sättigungsmagnetisierung gehalten werden. Die Sättigungsmagnetisierung bei der maximalen Flussdichte liegt bei etwa ein Drittel der maximalen Sättigung. Eine derartige Hochfrequenz-Schwingdrossel weist relativ geringe thermische Verluste auf.

Für Anwendungen, bei denen eine hohe Induktivität erforderlich ist, ist die Hochfrequenz-Schwingdrossel vorteilhaft, da sie eine hohe Windungszahl aufweist.

Die Wickel der Hochfrequenz-Schwingdrossel sind in einer Ausführungsform als herkömmliche Wickelspulen ausgeführt.

In einer bevorzugten Ausführungsform sind alle Lagen einer Wicklung gemeinsam aufgewickelt.

Bezüglich des Aufbaus der Wickel wird auf den Inhalt der DE 10 2008 016 488.7 Bezug genommen.

Durch diesen Aufbau des Wickels weist die Hochfrequenz-Schwingdrossel geringe Verluste durch Skin- sowie Proximity-Effekte bei hohen Frequenzen auf.

Durch diesen Aufbau des Wickels weist die Hochfrequenz-Schwingdrossel in dem Betrieb in einem Serienschwingkreis eine hohe Spannung auf, die sich über die komplette Länge der Wicklungen verteilt. Durch ihren Aufbau weist die Hochfrequenz-Schwingdrossel an keinem Punkt der Wicklungen signifikant höhere Windungsspannungen auf als die Zündspannung, bezogen auf die Gesamtzahl der Windungen.

In einer beispielhaften Ausführung der Hochfrequenz-Schwingdrossel weisen die Stabkerne jeweils einen Durchmesser von 11 mm bei einer Länge von 35 mm auf. Die Stabkerne weisen jeweils einen Wickel auf der 19 mm lang ist. Die Wickel haben einen Innendurchmesser von 13 mm und weisen 8 Lagen Draht auf. Die Drähte sind als Litzen ausgeführt die jeweils durch 8 gegeneinander verdrillte Einzeldrähte mit einem Durchmesser von 0,07 mm gebildet sind. Die Wickel weisen jeweils 55 Windungen auf. Die hier angegebenen Werte sind nur beispielhaft angegeben. Die Hochfrequenz-Schwingdrossel ist nicht auf dieses spezielle Ausführungsbeispiel beschränkt.

Zum Vergießen der Vergussmasse um die Hochfrequenz-Schwingdrossel ist eine Vorrichtung zum Vergießen der Hochfrequenz-Schwingdrossel angegeben, die einen Vergussbehälter umfasst. Der Vergussbehälter ist derart ausgebildet, dass die Stabkerne und die Wickel der Hochfrequenz-Schwingdrossel in dem Vergussbehälter fixiert sind. Der Vergussbehälter weist wenigstens zwei Paar Halterungsvorrichtungen auf, die die Stabkerne und die Wickel der Hochfrequenz-Schwingdrossel während des Gießens an ihrer vorgegebenen Position halten, sodass alle Bauteile einer Serie vorzugsweise die gleiche Induktivität aufweisen.

Der Vergussbehälter der Vorrichtung weist vorzugsweise eine Innenkontur auf, die die äußere Form der vergossenen Hochfrequenz-Schwingdrossel bestimmt.

Damit es bei der Hochfrequenz-Schwingdrossel zu keinen Teilentladungen beziehungsweise Überschlägen zu den Stabkernen kommt, wird die Hochfrequenz-Schwingdrossel mit einem flüssigen Kunststoff oder einem flüssigen Harz getränkt oder mit diesen vergossen. Zu diesem Zweck wird die Hochfrequenz-Schwingdrossel in der zuvor beschriebenen Vorrichtung fixiert und in einer Vakuumkammer getränkt und/oder vergossen. Während des Tränkens beziehungsweise des Vergießens wird die Luft zwischen den einzelnen Wicklungen der Wickel durch die Vergussmasse beziehungsweise durch Tränkflüssigkeit vorzugsweise vollständig verdrängt. Durch das Tränken beziehungsweise Vergießen der Hochfrequenz-Schwingdrossel werden Teilentladungen und/oder Überschläge zu den Stabkernen effektiv unterbunden beziehungsweise effektiv reduziert.

Durch den Aufbau der Hochfrequenz-Schwingdrossel sowie durch das anschließende Tränken und/oder den anschließenden Verguss der Hochfrequenz-Schwingdrossel weist diese Hochfrequenz-Schwingdrossel nur geringe Verluste auf. Im Resonanzfall der Hochfrequenz-Schwingdrossel auftretende Verluste können somit effektiv vermindert werden.

Vorzugsweise wird die Hochfrequenz-Schwingdrossel in einer Schaltungsanordnung mit einem LC-Serienschwingkreis verwendet, bei der eine hohe Aussteuerung mit hoher Güte der Hochfrequenz-Schwingdrossel gefordert ist. Hierbei wird die Hochfrequenz-Schwingdrossel vorzugsweise mit ungeradzahligen Oberwellen angesteuert, wobei die Oberwellen wenigstens die dritte Ordnung aufweisen. Bei der Ansteuerung mit der dritten Oberwelle einer Rechteck-Schwingung steht beispielsweise nur ein Drittel der angelegten Amplituden-Spannung der Grundwelle zur Verfügung, so dass die Hochfrequenz-Schwingdrossel im Betrieb in einem LC-Serienschwingkreis aufgrund der hohen Güte eine hohe Spannung generiert.

Die oben beschriebenen Gegenstände werden anhand der folgenden Figuren und Ausführungsbeispiele näher erläutert.

Die nachfolgend beschriebenen Zeichnungen sind nicht als maßstabsgerecht aufzufassen. Vielmehr können die Darstellungen in einzelnen Dimensionen vergrößert, verkleinert oder auch verzerrt dargestellt sein. Elemente, die einander gleichen oder die gleiche Funktion übernehmen, sind mit den gleichen Bezugszeichen bezeichnet.
- Figur 1: zeigt einen schematischen Aufbau eines ersten Ausführungsbeispiels einer Hochfrequenz-Schwingdrossel mit zwei Stabkernen,
- Figur 2: zeigt schematisch den Aufbau eines Wickels um einen Stabkern,
- Figur 3: zeigt schematisch einen Ausschnitt des Aufbaus eines Wickels,
- Figur 4: zeigt einen schematischen Aufbau eines weiteren Ausführungsbeispiels der Hochfrequenz-Schwingdrossel mit drei nebeneinander liegenden Stabkernen,
- Figur 5: zeigt den schematischen Aufbau einer Vorrichtung zum Verguss einer Hochfrequenz-Schwingdrossel mit zwei Stabkernen.

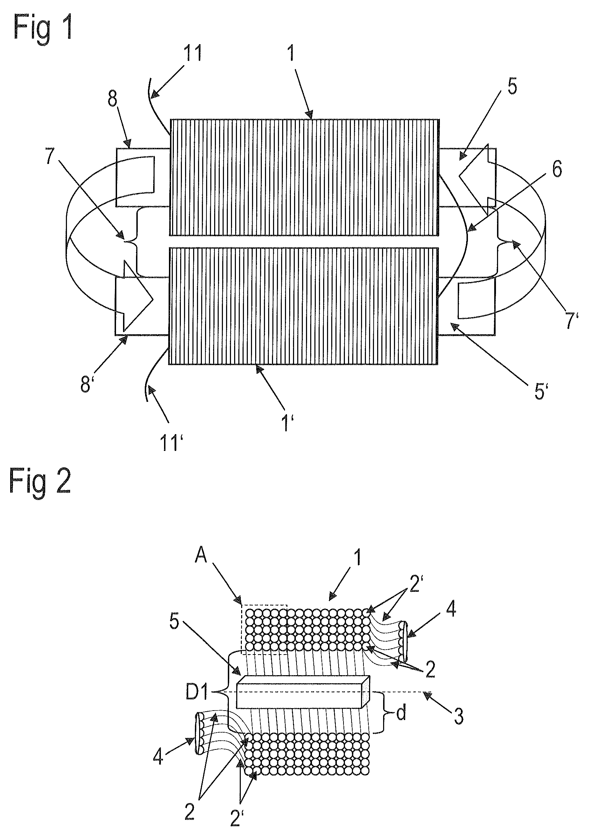

In Figur 1 ist ein schematischer Aufbau einer Ausführungsform einer Hochfrequenz-Schwingdrossel gezeigt, die zwei nebeneinander liegende Stabkerne 5, 5' aufweist. Die Stabkerne 5, 5' weisen jeweils einen Wickel 1, 1' auf. Die Wickel 1, 1' sind über eine Drahtbrücke 6 in Reihe geschaltet. Die Stabkerne 5, 5' weisen jeweils freie Enden 8, 8' auf, die frei von Wickeln 1, 1' sind. Im Bereich der freien Enden 8, 8' der Stabkerne 5, 5' weist der Magnetkreis der Hochfrequenz-Schwingdrossel jeweils einen Luftspalt auf, der auf zwei Teilluftspalte 7, 7' an den jeweiligen freien Enden 8, 8' der Stabkerne 5, 5' aufgeteilt ist. Die Flussrichtung des Magnetfeldes der Hochfrequenz-Schwingdrossel ist in der Ausführungsform durch die Pfeile an den jeweiligen freien Enden 8, 8' der Stabkerne 5, 5' dargestellt. Die Flussrichtung ist in der dargestellten Ausführungsform gegen den Uhrzeigersinn gerichtet. Zur elektrischen Kontaktierung der Hochfrequenz-Schwingdrossel weist diese Anschlusskontakte 11, 11' auf.

Figur 2 zeigt einen schematischen Aufbau eines Wickels 1 der beispielsweise im Aufbau einer Hochfrequenz-Schwingdrossel nach Figur 1 verwendet ist. Symbolisch sind nur zwei der fünf Wickellagen bezeichnet. Der Wickel 1 weist mehrere Wickellagen 2, 2' auf, die um eine gemeinsame Wickelachse 3 gewickelt sind. Der Abstand d der Wickellage 2 zur Wickelachse 3 des Wickels 1 ist über die gesamte Länge des Wickels 1 gleich groß. Die Abstände jeder weiteren Wickellage 2' zur Wickelachse 3 des Wickels 1 sind ebenfalls über die gesamte Länge des Wickels 1 annähernd konstant. Der Wickel 1 weist einen Innendurchmesser D1 auf, der über die gesamte Länge des Wickels 1 annähernd gleich groß ist. Die Wickellagen 2, 2' einer Wickelebene sind vorzugsweise gleichmäßig übereinander angeordnet. Durch ein gemeinsames Aufwickeln der einzelnen Wickellagen 2, 2' erreicht man, dass die Wickellagen 2, 2' direkt übereinander zu liegen kommen. Die einzelnen Wickellagen 2, 2' sind über die gesamte Länge des Wickels 1 parallel zueinander angeordnet und parallel geschaltet. An den Enden der Wickellagen 2, 2' sind elektrische Kontakte 4, 4' angeordnet, mit dem die einzelnen Wickellagen 2, 2' elektrisch miteinander verbunden sind. Über die elektrischen Kontakte 4, 4' kann der Wickel 1 elektrisch angeschlossen werden. Durch die Wicklungen der Wickellagen 2, 2' weist der Wickel 1 eine ausreichend große Stabilität auf, sodass der Wickel 1 ohne einen zusätzlichen Wickel- oder Spulenkörper auskommt. In der Wickelachse 3 des Wickels 1 ist ein ferrithaltiger Stabkern 5 eingeschoben.

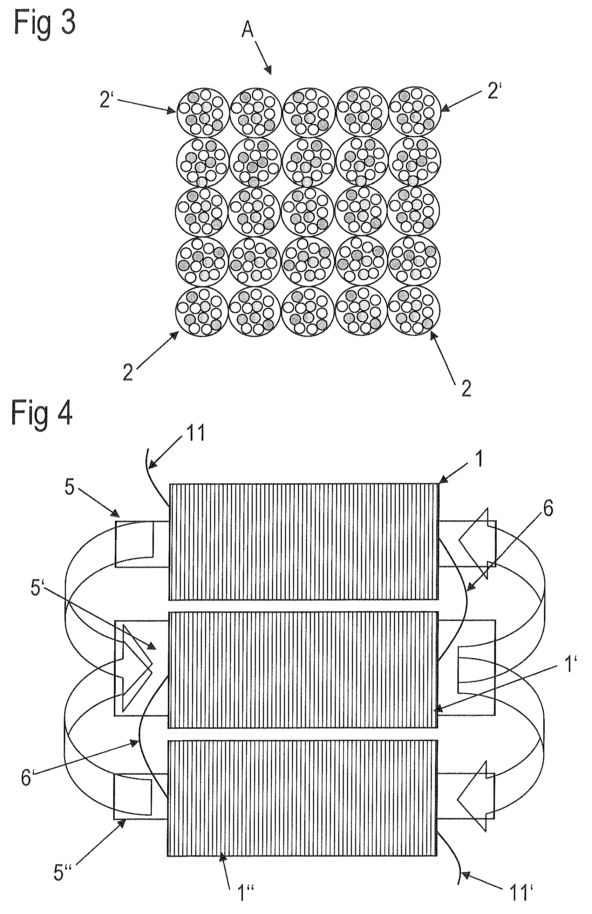

In der Figur 2 ist ein Bereich Teil der Windungen als Bereich A markiert, der in der Figur 3 vergrößert dargestellt ist.

In Figur 3 ist ein Ausschnitt des Wickels aus Figur 2 dargestellt. Die einzelnen Wickellagen 2, 2' umfassen in der Figur 3 jeweils mehrere Litzendrähte. Dabei weist jede der Litzen zirka zwölf einzelne Drähte auf, die gegeneinander verdrillt sind. Die Wickellagen 2, 2' können jedoch aus einzelnen Drähten, rechteckigen Flachdrähten oder aus einer anderen Drahtform bestehen. Die einzelnen Wickellagen 2, 2' sind exakt übereinander angeordnet. Der Abstand der ersten Wickellage 2 zur Wickelachse des Wickels 1 ist über die gesamte Länge annähernd gleich groß. Direkt über der ersten Wickellage 2 sind weitere Wickellagen 2' angeordnet, die gemeinsam mit der ersten Wickellage 2 um eine gemeinsame Wickelachse gewickelt sind.

Figur 4 zeigt den schematischen Aufbau einer weiteren Ausführungsform einer Hochfrequenz-Schwingdrossel, die drei nebeneinander liegende Stabkerne 5, 5', 5" aufweist. Der mittlere Stabkern 5' weist größere Abmessungen auf als die außen liegenden Stabkerne 5, 5''. Die Stabkerne 5, 5', 5" weisen jeweils einen Wickel 1, 1', 1" auf. Die Wickel 1, 1', 1" sind mittels Drahtbrücken 6, 6' in Serie geschaltet. Die Wickel 1, 1', 1" der Hochfrequenz-Schwingdrossel sind derart angeordnet, dass zwei nebeneinander liegende Wickel 1, 1', 1" der Hochfrequenz-Schwingdrossel eine entgegengesetzte Wickelrichtung aufweisen. Der Magnetkreis der oberen beiden nebeneinander liegenden Stabkerne 5, 5' verläuft gegen den Uhrzeigersinn. Der Magnetkreis des mittleren Stabkerns 5' und des unteren Stabkerns 5" verläuft in Richtung des Uhrzeigersinns. Im mittleren Stabkern 5' überlagern sich die beiden Magnetkreise. Die freien Wickelenden des Wickels 1 und des Wickels 1", die nicht über Drahtbrücken 6, 6' mit dem weiteren Wickel 1' verbunden sind, weisen Anschlusskontakte 11, 11' zur elektrischen Außenkontaktierung der Hochfrequenz-Schwingdrossel auf.

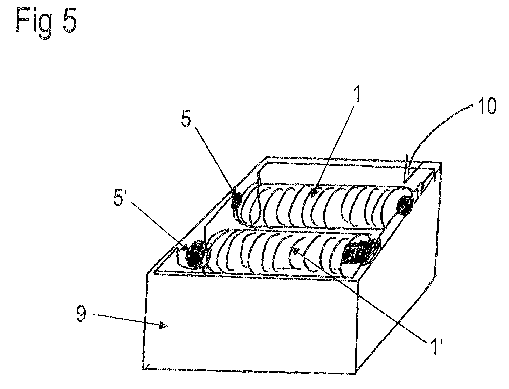

Figur 5 zeigt schematisch den Aufbau einer Vorrichtung zum Vergießen einer Hochfrequenz-Schwingdrossel. Die Vorrichtung umfasst einen Vergussbehälter 9. Der Vergussbehälter 9 weist eine wannenförmige Gestalt auf. Die Wanne umfasst wenigstens vier Seitenwände, einen Boden und eine nach oben offene Seite. Die Innenkontur 10 des Vergussbehälters 9 ist negativ zu der Form der vergossenen Hochfrequenz-Schwingdrossel geformt. In dem Vergussbehälter 9 ist eine Hochfrequenz-Schwingdrossel mit zwei Stabkernen 5, 5' positioniert. Auf den Stabkernen 5, 5' ist jeweils ein Wickel 1, 1' angeordnet. Durch den Vergussbehälter 9 werden die Stabkerne 5, 5' und die Wickel 1, 1' der Hochfrequenz-Schwingdrossel während des Gießens gehalten und durch die ausgehärtete Vergussmasse anschließend fixiert. Die vergossene Hochfrequenz-Schwingdrossel wird anschließend aus dem Vergussbehälter entnommen, so dass eine weitere Hochfrequenz-Schwingdrossel vergossen werden kann.

Obwohl in den Ausführungsbeispielen eine beschränkte Anzahl möglicher Weiterbildungen der Erfindung beschrieben werden konnte, ist die Erfindung nicht auf diese beschränkt. Es ist prinzipiell möglich, dass die Hochfrequenz-Schwingdrossel mehrere Stabkerne aufweist oder auch mehrere voneinander beabstandete Wickel auf einem Stabkern umfasst.

Die Erfindung ist nicht auf die Anzahl der dargestellten Elemente beschränkt.

Die Beschreibung der hier angegebenen Gegenstände ist nicht auf die einzelnen speziellen Ausführungsformen beschränkt, vielmehr können die Merkmale der einzelnen Ausführungsformen, soweit technisch sinnvoll, beliebig miteinander kombiniert werden.

### Bezugszeichenliste

- 1, 1', 1": Wickel
- 2, 2': Wickellage
- 3: Wickelachse
- 4: elektrische Kontakte
- 5, 5', 5": Stabkern
- 6, 6': Drahtbrücke
- 7, 7': Teilluftspalt
- 8, 8': freies Ende des Stabkerns 5
- 9: Vergussbehälter
- 10: Innenkontur des Vergussbehälters 9
- 11, 11': Anschlusskontakte
- A: Ausschnitt
- d: Abstand von einer Wickellage 2, 2' zur Wickelachse 3
- D1: Innendurchmesser des Wickels 1

## Patentansprüche

1. Hochfrequenz-Schwingdrossel, aufweisend
wenigstens zwei in Längsrichtung nebeneinander angeordnete Stabkerne (5, 5'), die jeweils wenigstens einen Wickel (1, 1') aufweisen,
wobei die Wickel (1, 1') in Serie geschaltet sind,
wobei der Magnetkreis der Schwingdrossel wenigstens einen Luftspalt aufweist,
**dadurch gekennzeichnet, dass** die wickellagen (2, 2') der Wickel (1, 1') übereinander angeordnet sind und an ihren Enden elektrisch miteinander verbunden sind, wodurch die Wickellagen (2, 2') zueinander parallel geschaltet sind.

2. Hochfrequenz-Schwingdrossel nach Anspruch 1,
wobei die Wickelrichtungen der wenigstens zwei Wickel (1, 1') entgegengesetzt gerichtet sind.

3. Hochfrequenz-Schwingdrossel nach einem der Ansprüche 1 oder 2,
wobei der Luftspalt in wenigstens zwei Teilluftspalte (7, 7') im Bereich der wickelfreien Enden (8, 8') der zwei nebeneinander angeordneten Stabkerne (5, 5') aufgeteilt ist.

4. Hochfrequenz-Schwingdrossel nach einem der vorhergehenden Ansprüche,
wobei ein Teil der Stabkerne (5, 5') in Längsrichtung von den Wickeln (1, 1') umgeben ist.

5. Hochfrequenz-Schwingdrossel nach Anspruch 4,
wobei mindestens 50 % der Länge eines Stabkerns (5, 5') vom Wickel (1, 1') umgeben ist.

6. Hochfrequenz-Schwingdrossel nach einem der vorhergehenden Ansprüche,
wobei die Wickel (1, 1') eine Schutzschicht aus Kunststoff aufweisen.

7. Hochfrequenz-Schwingdrossel nach einem der vorhergehenden Ansprüche,
wobei die freien Enden der Wickel (1, 1') als lötfähige Kontakte ausgebildet sind.

8. Hochfrequenz-Schwingdrossel nach einem der vorhergehenden Ansprüche,
die eine maximale Flussdichte der Stabkerne (5, 5') aufweist, die maximal ein Drittel der Sättigungsmagnetisierung der Stabkerne (5, 5') beträgt.

9. Hochfrequenz-Schwingdrossel nach einem der vorhergehenden Ansprüche,
wobei die Stabkerne (5, 5') Ferrit umfassen.

10. Hochfrequenz-Schwingdrossel nach einem der vorhergehenden Ansprüche,
wobei die Wickel (1, 1') mehrere Wickellagen (2, 2') umfassen die über die gesamte Länge der Wickel (1, 1') jeweils einen konstanten Abstand (d) zu der Wickelachse (3) der Wickel (1, 1') aufweisen.

11. Hochfrequenz-Schwingdrossel nach einem der Ansprüche 1 bis 6,
die mit einer Vergussmasse umhüllt ist.

12. Verfahren zum Vergießen einer Hochfrequenz-Schwingdrossel nach einem der vorhergehenden Ansprüche, umfassend:
Fixieren von Stabkernen (5, 5') und Wickeln (1, 1') der Hochfrequenz-Schwingdrossel nach einem der vorhergehenden Ansprüche in einem Vergussbehälter (9).

13. Verfahren nach Anspruch 12,
wobei der Vergussbehälter (9) eine Innenkontur (10) aufweist, die die äußere Form der vergossenen Schwingdrossel bestimmt.

14. Verfahren nach einem der Ansprüche 12 oder 13,
wobei die Hochfrequenz-Schwingdrossel während des Gießens durch den Vergussbehälter gehalten wird und durch eine ausgehärtete Vergussmasse fixiert wird.

15. Schaltungsanordnung einer Hochfrequenz-Schwingdrossel nach einem der vorhergehenden Ansprüche, die in einem LC-Serienschwingkreis bei einer n-ten Oberwelle einer Rechteck-Schwingung betrieben wird, wobei n ungeradzahlig und ≥ 3 ist.

## Claims

1. High-frequency swinging choke, having at least two rod cores (5, 5') arranged next to one another in the longitudinal direction, each rod core having at least one winding (1, 1'),
wherein the windings (1, 1') are connected in series, wherein the magnetic circuit of the swinging choke has at least one air gap,
**characterized in that** the winding layers (2, 2') of the windings (1, 1') are arranged one over the other and are electrically connected to one another at their ends, whereby the winding layers (2, 2') are connected in parallel with one another.

2. High-frequency swinging choke according to Claim 1,
wherein the winding directions of the at least two windings (1, 1') are oppositely directed.

3. High-frequency swinging choke according to either of Claims 1 and 2,
wherein the air gap is divided into at least two partial air gaps (7, 7') in the region of the windingfree ends (8, 8') of the two rod cores (5, 5') arranged next to one another.

4. High-frequency swinging choke according to one of the preceding claims,
wherein part of the rod cores (5, 5') is surrounded by the windings (1, 1') in the longitudinal direction.

5. High-frequency swinging choke according to Claim 4,
wherein at least 50% of the length of a rod core (5, 5') is surrounded by the winding (1, 1').

6. High-frequency swinging choke according to one of the preceding claims,
wherein the windings (1, 1') have a protective coating made of plastic.

7. High-frequency swinging choke according to one of the preceding claims,
wherein the free ends of the windings (1, 1') are formed as solderable contacts.

8. High-frequency swinging choke according to one of the preceding claims,
which has a maximum flux density of the rod cores (5, 5') that is at most one third of the saturation magnetization of the rod cores (5, 5').

9. High-frequency swinging choke according to one of the preceding claims,
wherein the rod cores (5, 5') comprise ferrite.

10. High-frequency swinging choke according to one of the preceding claims,
wherein the windings (1, 1') comprise a plurality of winding layers (2, 2') that are each at a constant distance (d) from the winding axis (3) of the windings (1, 1') over the entire length of the windings (1, 1').

11. High-frequency swinging choke according to one of Claims 1 to 6,
which is encased with a casting compound.

12. Method for casting a high-frequency swinging choke according to one of the preceding claims, comprising:
fixing rod cores (5, 5') and windings (1, 1') of the high-frequency swinging choke according to one of the preceding claims in a casting container (9).

13. Method according to Claim 12,
wherein the casting container (9) has an inner contour (10) that determines the outer form of the cast swinging choke.

14. Method according to either of Claims 12 and 13,
wherein the high-frequency swinging choke is held during the casting by the casting container and is fixed by a cured casting compound.

15. Circuit arrangement of a high-frequency swinging choke according to one of the preceding claims, which is operated in an LC series resonant circuit at an nth harmonic of a rectangular oscillation, wherein n is an odd number and ≥ 3.

## Revendications

1. Bobine oscillatrice à haute fréquence, possédant au moins deux noyaux en barre (5, 5') disposés l'un à côté de l'autre dans le sens longitudinal, lesquels possèdent respectivement au moins un enroulement (1, 1'),
les enroulements (1, 1') étant branchés en série,
le circuit magnétique de la bobine oscillatrice possédant au moins un entrefer,
**caractérisée en ce que** les couches d'enroulement (2, 2') des enroulements (1, 1') sont disposées l'une au-dessus de l'autre et sont reliées électriquement l'une à l'autre au niveau de leurs extrémités, les couches d'enroulement (2, 2') étant ainsi branchées en parallèle l'une à l'autre.

2. Bobine oscillatrice à haute fréquence selon la revendication 1, avec laquelle les sens d'enroulement des au moins deux enroulements (1, 1') est orientés à l'opposé.

3. Bobine oscillatrice à haute fréquence selon l'une des revendications 1 ou 2, avec laquelle l'entrefer est divisé en au moins deux entrefers partiels (7, 7') dans la zone des extrémités exemptes d'enroulement (8, 8') des deux noyaux en barre (5, 5') disposés l'un à côté de l'autre.

4. Bobine oscillatrice à haute fréquence selon l'une des revendications précédentes, avec laquelle une partie des noyaux en barre (5, 5') est entourée par les enroulements (1, 1') dans le sens longitudinal.

5. Bobine oscillatrice à haute fréquence selon la revendication 4, avec laquelle au moins 50 % de la longueur d'un noyau en barre (5, 5') sont entourés par l'enroulement (1, 1').

6. Bobine oscillatrice à haute fréquence selon l'une des revendications précédentes, avec laquelle les enroulements (1, 1') possèdent une couche de protection en matière plastique.

7. Bobine oscillatrice à haute fréquence selon l'une des revendications précédentes, avec laquelle les extrémités libres des enroulements (1, 1') sont réalisées sous la forme de contacts pouvant être brasés.

8. Bobine oscillatrice à haute fréquence selon l'une des revendications précédentes, laquelle possède une densité de flux maximale des noyaux en barre (5, 5'), laquelle est au maximum égale à un tiers de la saturation magnétique des noyaux en barre (5, 5').

9. Bobine oscillatrice à haute fréquence selon l'une des revendications précédentes, avec laquelle les noyaux en barre (5, 5') comprennent de la ferrite.

10. Bobine oscillatrice à haute fréquence selon l'une des revendications précédentes, avec laquelle les enroulements (1, 1') comprennent plusieurs couches d'enroulement (2, 2') qui, sur toute la longueur des enroulements (1, 1'), possèdent respectivement un écart constant (d) par rapport à l'axe d'enroulement (3) des enroulements (1, 1').

11. Bobine oscillatrice à haute fréquence selon l'une des revendications 1 à 6, laquelle est enveloppée avec une masse de scellement.

12. Procédé d'encapsulation d'une bobine oscillatrice à haute fréquence selon l'une des revendications précédentes, comprenant :
fixation de noyaux en barre (5, 5') et d'enroulements (1, 1') de la bobine oscillatrice à haute fréquence selon l'une des revendications précédentes dans un récipient d'encapsulation (9).

13. Procédé selon la revendication 12, selon lequel le récipient d'encapsulation (9) possède un contour intérieur (10) qui définit la forme extérieure de la bobine oscillatrice encapsulée.

14. Procédé selon l'une des revendications 12 ou 13, selon lequel la bobine oscillatrice à haute fréquence est maintenue par le récipient d'encapsulation pendant la coulée et fixée par une masse de scellement durcie.

15. Arrangement de circuit d'une bobine oscillatrice à haute fréquence selon l'une des revendications précédentes, laquelle est utilisée dans un circuit oscillant série avec une n^{ème} onde harmonique d'une oscillation rectangulaire, n étant un nombre impair et étant ≥ 3.
